# EUROPEAN PATENT APPLICATION

(11) **EP 3 144 966 A2**
(43) Date of publication of application: **22.03.2017**
(21) Application number: 16191958.4
(22) Date of filing: 25.10.2011
(51) Int. Cl.: H01L 23/28, H01L 23/48, H01L 21/56, H01L 23/31, H01L 21/60, H01L 23/485, H01L 25/10

(54) **ENCAPSULATED DIE, MICROELECTRONIC PACKAGE CONTAINING SAME, AND METHOD OF MANUFACTURING SAID MICROELECTRONIC PACKAGE**

(30) Priority: 05.11.2010 US 940446
(62) Divisional of application: 11838496.5
(71) Applicant: Intel Corporation, Santa Clara, CA 95054 (US)
(72) Inventor: GUZEK, John S., 85248 Chandler, AZ (DE); SANKMAN, Robert L., Phoenix, AZ Arizona 85044 (US); ICHIKAWA, Kinya, Tsukuba-Shi Ibaraki-ken, Ibaraki 305-0046 (JP); TOMITA, Yoshihiro, Tsukuba Ibaraki, Ibaraki 300-2635 (JP); KUBOTA, Jiro, Tsukuba-Shi, Ibaraki 305-0045 (JP)
(74) Representative: Rummler, Felix

(57) **Abstract**

An encapsulated die (100, 401) comprises a substrate (110, 510) having a first surface (111), an opposing second surface (112), and intervening side surfaces (113), with active devices located at the first surface of the substrate. The active devices are connected by a plurality of electrically conductive layers (120, 520) that are separated from each other by a plurality of electrically insulating layers (125, 525). A protective cap (130, 530) located over the first surface of the substrate extends at least partially over the intervening side surfaces and contains an interconnect structure (140) exposed at a surface (131) thereof. In another embodiment, a microelectronic package (200) comprises a package substrate (250) with an encapsulated die (100) such as was described above embedded therein.

## Description

### FIELD OF THE INVENTION

The disclosed embodiments of the invention relate generally to microelectronic packaging, and relate more particularly to embedded die packages.

### BACKGROUND OF THE INVENTION

The embedded die package is a packaging architecture that can enable very thin, stackable packages (e.g., Package-on-Package and similar constructs), with a very scalable die interconnect. However, the microelectronic dies that go into such packages, being very thin themselves, are especially vulnerable to warpage and instability as well as to die cracking, delamination, and other die-level failure modes.

### BRIEF DESCRIPTION OF THE DRAWINGS

The disclosed embodiments will be better understood from a reading of the following detailed description, taken in conjunction with the accompanying figures in the drawings in which:
FIG. 1 is a cross-sectional view of an encapsulated die according to an embodiment of the invention;
FIGs. 2A and 2B are cross-sectional views of a microelectronic package containing an encapsulated die according to embodiments of the invention;
FIG. 3 is a flowchart illustrating a method of manufacturing a microelectronic package according to an embodiment of the invention; and
FIGs. 4 and 5 are plan and cross-sectional views, respectively, of a wafer used in the manufacture of encapsulated dies according to embodiments of the invention.

For simplicity and clarity of illustration, the drawing figures illustrate the general manner of construction, and descriptions and details of well-known features and techniques may be omitted to avoid unnecessarily obscuring the discussion of the described embodiments of the invention. Additionally, elements in the drawing figures are not necessarily drawn to scale. For example, the dimensions of some of the elements in the figures may be exaggerated relative to other elements to help improve understanding of embodiments of the present invention. The same reference numerals in different figures denote the same elements, while similar reference numerals may, but do not necessarily, denote similar elements.

The terms "first," "second," "third," "fourth," and the like in the description and in the claims, if any, are used for distinguishing between similar elements and not necessarily for describing a particular sequential or chronological order. It is to be understood that the terms so used are interchangeable under appropriate circumstances such that the embodiments of the invention described herein are, for example, capable of operation in sequences other than those illustrated or otherwise described herein. Similarly, if a method is described herein as comprising a series of steps, the order of such steps as presented herein is not necessarily the only order in which such steps may be performed, and certain of the stated steps may possibly be omitted and/or certain other steps not described herein may possibly be added to the method. Furthermore, the terms "comprise," "include," "have," and any variations thereof, are intended to cover a non-exclusive inclusion, such that a process, method, article, or apparatus that comprises a list of elements is not necessarily limited to those elements, but may include other elements not expressly listed or inherent to such process, method, article, or apparatus.

The terms "left," "right," "front," "back," "top," "bottom," "over," "under," and the like in the description and in the claims, if any, are used for descriptive purposes and not necessarily for describing permanent relative positions unless otherwise indicated either specifically or by context. It is to be understood that the terms so used are interchangeable under appropriate circumstances such that the embodiments of the invention described herein are, for example, capable of operation in other orientations than those illustrated or otherwise described herein. The term "coupled," as used herein, is defined as directly or indirectly connected in an electrical or non-electrical manner. Objects described herein as being "adjacent to" each other may be in physical contact with each other, in close proximity to each other, or in the same general region or area as each other, as appropriate for the context in which the phrase is used. Occurrences of the phrase "in one embodiment" herein do not necessarily all refer to the same embodiment.

### DETAILED DESCRIPTION OF THE DRAWINGS

In one embodiment of the invention, an encapsulated die comprises a substrate having a first surface, an opposing second surface, and intervening side surfaces, with active devices located at the first surface of the substrate. The active devices are connected by a plurality of electrically conductive layers that are separated from each other by a plurality of electrically insulating layers. A protective cap is located over the first surface of the substrate contains an interconnect structure exposed at a surface thereof. In another embodiment, a microelectronic package comprises a package substrate with an encapsulated die such as was described above embedded therein.

Embodiments of the invention have the potential to make the die embedding process simpler and to improve the reliability of the microelectronic device-both during transportation to the embedding facility and in the end application. As an example, one or more embodiments may reduce the warpage exhibited by singulated dies (prior to embedding). At very low die thicknesses the die tends to warp because of the relatively large difference between the coefficient of thermal expansion (CTE) of the metal and dielectric layers on the surface of the wafer and the CTE of the die itself. By placing a low-CTE mold compound on the surface of the die, the warpage should be reduced, thus improving die reliability, and this in turn may make the embedding process easier. Furthermore, the risk of die damage during transportation may be reduced because the encapsulated surface and edges of the die will provide greater protection against mechanical damage. These and other advantages will be discussed in more detail below.

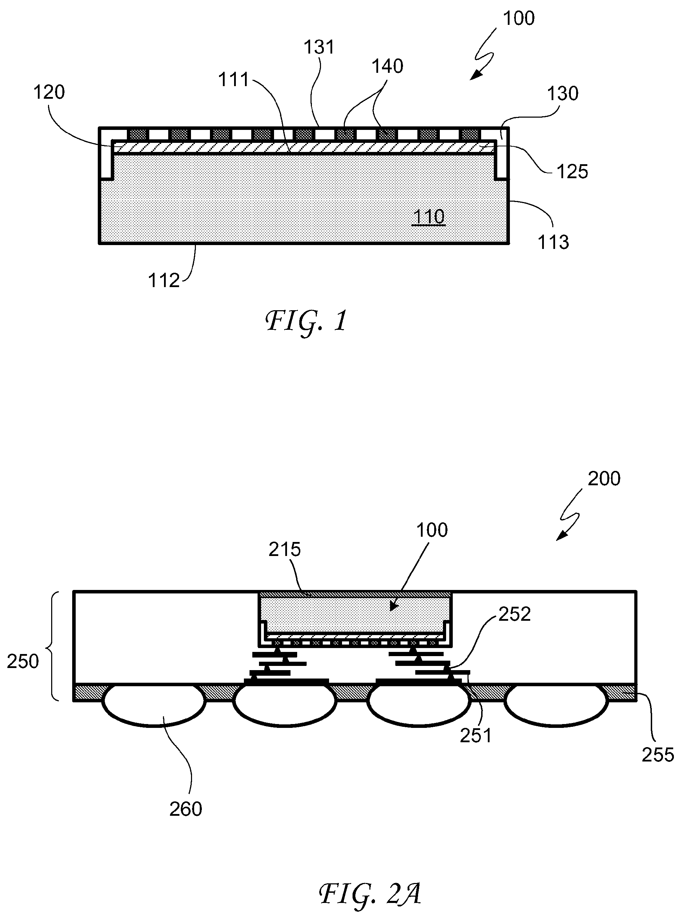

Referring now to the drawings, FIG. 1 is a cross-sectional view of an encapsulated die 100 according to an embodiment of the invention. As illustrated in FIG. 1, encapsulated die 100 comprises a substrate having a surface 111, an opposing surface 112, and intervening side surfaces 113. Active devices (too small to be seen at the scale of FIG. 1) are located at surface 111 of substrate 110, and the active devices are adjacent to a plurality of electrically conductive layers 120 that are separated from each other by a plurality of electrically insulating layers 125. As an example, the electrically conductive layers 120 and the electrically insulating layers 125 can be, respectively, the usual metal and interlayer dielectric (ILD) materials that form the build-up layers of embedded die or flip-chip packages as known in the art.

Encapsulated die 100 further comprises a protective cap 130 over surface 111 of substrate 110. It is this protective cap that gives encapsulated die 100 its name: the protective cap takes the form of a molded encapsulant or the like that is applied to (encapsulates) the die. The protective cap applied to the die effectively makes the die a wafer level package.

Protective cap 130 has a surface 131 and contains an interconnect structure 140 exposed at that surface. In one embodiment the protective cap is applied directly on the metal and ILD layers after the interconnect structures (e.g., controlled collapse chip connect (C4) bumps) have been formed. In that embodiment, the protective cap covers the metal and ILD layers and at least partially surrounds some or all of the interconnect structures. In certain embodiments a passivation layer (not shown in the drawings) would be located over the metal and ILD layers and the protective cap would be applied directly on top of that. Protective cap material that covers the interconnect structures must be removed so that the interconnect structures can function properly.

The protective cap stiffens and reinforces die 100 and can help protect the interconnect structures. In one embodiment, protective cap 130 comprises a polymer mold compound. As an example, the polymer mold compound may contain silica or other filler particles. Silica particles may be used in order to add stiffness to the mold compound as well as to lower its CTE so as to bring it closer to that of silicon. One potential effect of the closer CTE match is a reduction in die warpage, resulting in a flatter die (flatter dies are easier to handle and work with). In other embodiments, protective cap 130 can comprise, for example, various epoxy systems, polyimide systems, cyanate esters (especially where a higher glass transition temperature is desired), thermoplastics such as liquid crystal polymer and the like (suitable for use with injection molding).

Polymers may be applied to surfaces in a variety of ways, and any of these methods (e.g., molding, liquid dispense, lamination using a dry film of encapsulant) may be used in order to apply protective cap 130 to encapsulated die 100. Molding may often be an appropriate choice because it is inexpensive, it's compatible with high volume manufacturing environments, and the materials usable with the various molding processes (e.g., compression molding, transfer molding, injection molding) offer a lot of flexibility in terms of their mechanical properties.

In the illustrated embodiment, protective cap 130 covers not only surface 111 of substrate 110 (with electrically conductive layers 120 and electrically insulating layers 125 in between the cap and the surface, as shown) but also extends for a certain distance along side surfaces 113. This occurs, even where the mold compound or other encapsulant is applied at wafer level (i.e., applied before die singulation), as a result of a die preparation process in which a laser pre-cut is employed to cut through some of the upper layers that have been formed on the wafer, such as the sensitive dielectric and metal layers that might be damaged if a larger and less-precise saw blade were used. In embodiments where protective cap 130 is applied prior to the full saw cut but after the laser scribe, the mold compound or other protective material of protective cap 130 will be applied on side surfaces 113 down to the level exposed by the laser scribe. The subsequent singulation process (e.g., the full saw cut) would then cut first through the protective cap in the trench created by the laser scribe and then through the remaining portion of the wafer (typically just bulk silicon) that was not removed by the laser. By protecting the die, and particularly the metal and dielectric layers, in this way, damage due to stresses arising both during and after package assembly can be reduced, as can performance issues due to moisture entrapment along the die edge.

In one embodiment, the polymer mold compound has a CTE between approximately 5 and 12. A CTE in this range is characteristic of a mold compound having enhanced mechanical stability, which can be especially useful when used with thin, and therefore fragile, dies. As mentioned above, the CTE of the polymer mold compound may be brought into the given range by adding silica to the mold compound. Other additives, and other methods for adjusting CTE, may also be used.

In another embodiment, the polymer mold compound has a Young's modulus less than 10 GPa. A Young's modulus in the given range is characteristic of a softer mold compound having increased flexibility, in contrast to the more rigid compound described in the previous paragraph, so as to produce a cushioning effect that may act as a stress buffer. The decision regarding whether to use a more rigid material or a softer material would depend to at least some degree on the requirements of a particular application. As mentioned above, the molding process is compatible with a selection of materials that is broad enough to cover a wide spectrum of possible application requirements.

As illustrated in FIG. 1, a plurality of interconnect structures 140 are exposed at surface 131 of protective cap 130, and each one of these interconnect structures is substantially co-planar with each other one of the interconnect structures. Such planarized interconnect structures (which may, for example, comprise copper pads or the like) will advantageously present a very uniform structure during the build-up process. The uniform surface will simplify the build-up process by eliminating the bump height tolerance that would otherwise need to be accounted for.

If desired, surface 131 of protective cap 130 may be mechanically roughened so as to provide enhanced adhesion between the protective cap and the build-up dielectric layers. For example, plasma or chemical etching can be used to impart a roughness on the order of 0.2 micrometers (hereinafter "microns" or "µm") to about 1.0 µm. Providing protective cap 130 with silica will likely also increase adhesion between the cap and the dielectric layers because silica bonds very nicely to epoxy and the dielectric is an epoxy material. Moreover, the silica will add roughness for purposes of mechanical interlocking. The silica particles may be exposed, for example, when the die is ground back in order to thin it.

FIG. 2A is a cross-sectional view of a microelectronic package 200 according to an embodiment of the invention in which die 100 is fully embedded within the package. As an example, an embedded die package such as the one illustrated in FIG. 2A may result from attaching the die to an un-etched copper foil.

As illustrated in FIG. 2A, microelectronic package 200 comprises a package substrate 250 having encapsulated die 100 embedded therein. As indicated by the reference numeral, this is the same encapsulated die that was introduced and described in connection with FIG. 1, and it contains all of the same features (even though they are not labeled again in FIG. 2A). Encapsulated die 100 in FIG. 2A contains an additional feature not shown in FIG. 1: a die backside film 215. This is an optional feature that may be put into place if additional protection for side 112 of encapsulated die 100 is desired.

Package substrate 250 includes electrically insulating layers and electrically conductive traces built-up over and around the die as is typical for an embedded die package. Conductive traces 251 and via structures 252 are illustrated in FIG. 2A as connecting an interconnect structure 140 on encapsulated die 100 to a bump or other interconnect structure 260 (such as a ball grid array (BGA) ball, for example) that connects microelectronic package 200 to a board or other next level component. For simplicity, only a few conductive traces are shown in FIG. 2A; other such traces would likely also be present (even though they are not illustrated) in order to enable additional electrical connections. A layer 255 in FIG. 2A represents a solder resist layer that serves to define pads (not shown) on a bottom side of microelectronic package 200 (i.e., the side where interconnect structure 260 is located).

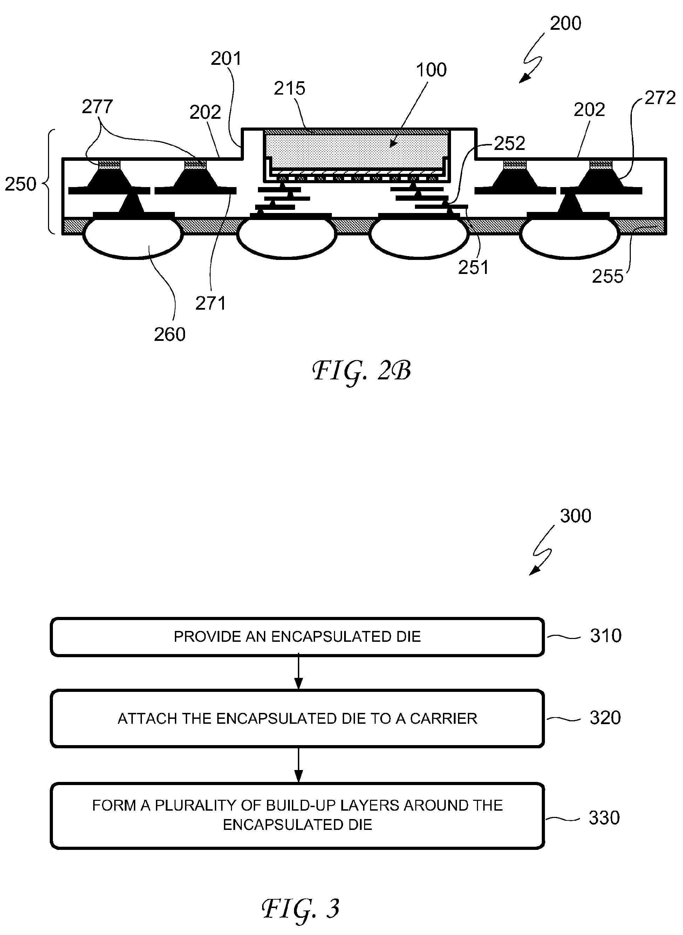

FIG. 2B is a cross-sectional view of microelectronic package 200 according to an embodiment of the invention in which a package region 201 that contains die 100 protrudes above a package portion 202 that does not contain die 100. This package configuration may be used when additional packages or other components are to be stacked on top of microelectronic package 200.

As set forth above in the discussion of FIG. 2A, the surface of a package having a "fully embedded" configuration is substantially flat across the entire side enclosing the backside of the die. As may be seen, the FIG. 2B configuration does have that "fully embedded" configuration but nevertheless may still be referred to as "embedded" in that the die is enclosed or surrounded by the build-up layers. To the extent necessary herein, the two configurations will be distinguished by referring to them as "fully embedded" (for the FIG. 2A configuration) and as simply "embedded" (for the FIG. 2B configuration). As an example, an embedded die package such as the one illustrated in FIG. 2B may result from a process flow in which the die is attached into a cavity in a copper foil or other carrier.

In addition to conductive traces 251 and vias 252 (both of which were introduced in FIG. 2A), microelectronic package 200 as illustrated in FIG. 2B also comprises conductive traces 271 and vias 272 that form an electrical pathway between interconnect structure 260 and package portion 202 where package-on-package (POP) pads or the like (not shown) may be located and used for package stacking. In the illustrated embodiment, vias 272 include a surface finish stack 277. As an example, the surface finish stack may comprise one or more layers (three are illustrated) of nickel, gold, palladium, and/or similar materials.

It may be seen that microelectronic package 200 is an embedded die coreless package. (It should be noted that embodiments of the invention may also encompass embedded die packages with cores.) Among other advantages, embedded die coreless packaging provides a way to significantly constrain package height while allowing very fine substrate design rules that can in turn enable silicon scaling and lower die costs. Microelectronic package 200 with its encapsulated die embedded therein improves both the embedding process and the reliability of the final package, as detailed elsewhere herein.

FIG. 3 is a flowchart illustrating a method 300 of manufacturing a microelectronic package according to an embodiment of the invention. As an example, method 300 may result in the formation of a microelectronic package that is similar to microelectronic package 200 that is shown in either of FIGs. 2A and 2B.

A step 310 of method 300 is to provide an encapsulated die comprising a substrate having a first surface, an opposing second surface, and intervening side surfaces, further comprising active devices that are located at the first surface of the substrate and that are connected by a plurality of electrically conductive layers that are separated from each other by a plurality of electrically insulating layers, and also comprising a protective cap over the first surface of the substrate and at least a portion of the intervening side surfaces and that contains an interconnect structure exposed at a surface thereof. The presence of the protective cap means that die reliability in the final package configuration will be improved: as was mentioned above, the CTE mismatch between silicon and the surrounding package dielectric layers will drive stress in the silicon; a low or intermediate CTE encapsulant on the die surface will introduce a beneficial "stress buffering" effect.

As an example, the encapsulated die can be similar to encapsulated die 100 that is shown in FIG. 1. Accordingly, the first surface, the opposing second surface, and the intervening side surfaces can be similar to, respectively, surface 111, surface 112, and surfaces 113 that are shown in FIG. 1. Additionally, the electrically conductive layers and the electrically insulating layers can be similar to, respectively, electrically conductive layers 120 and electrically insulating layers 125 that are also shown in FIG. 1. The protective cap can be similar to protective cap 130 that is shown in FIG. 1, and the interconnect structure can be similar to interconnect structure 140, also shown in FIG. 1.

In one embodiment, the protective cap adheres to the outermost layer of the die, meaning that it is applied over the metal and ILD layers, over the passivation layer, and over the interconnect structures. After the protective cap is formed it may have to be ground back in order to expose all of the interconnect structures.

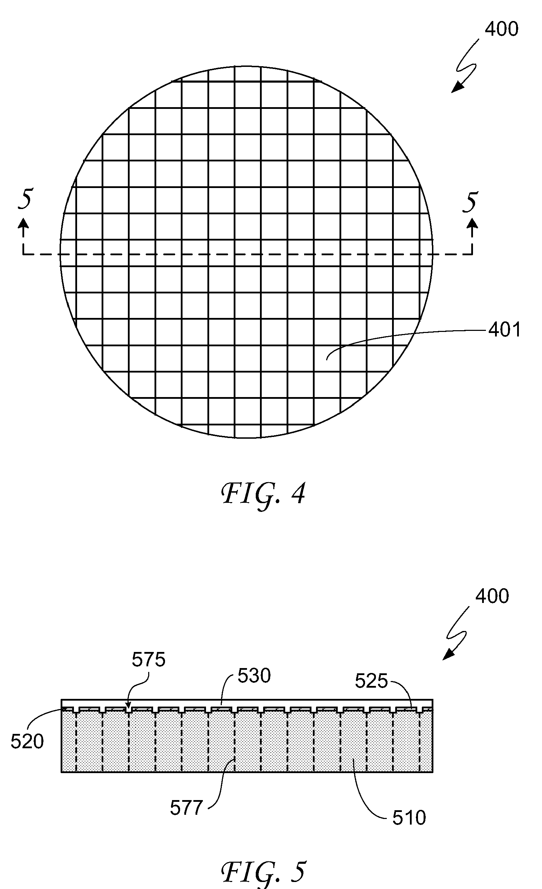

In one embodiment, the encapsulated die is formed on a wafer together with a plurality of other dies as illustrated in FIGs. 4 and 5. In FIG. 4, which is a plan view of a wafer 400 according to an embodiment of the invention, a plurality of dies including a die 401 are illustrated. The vertical and horizontal lines in FIG. 4 indicate borders of each individual die region, and it is roughly along these lines that the dies may be separated from each other (singulated).

FIG. 5 is a cross-sectional view of wafer 400 (taken along line 5-5 in FIG. 4) showing how a protective cap 530 has been applied across the entire wafer 400 following the creation of laser scribes 575 but prior to die singulation. In the illustrated embodiment, the laser scribe extends through electrically conductive layers 520 and electrically insulating layers 525 that are formed on an upper layer of wafer 400 and into the bulk silicon (or other material) of a substrate 510. This means that protective cap 530 is applied not only over the top but also along the sides of electrically conductive layers 520 and electrically insulating layers 525. When the dies are subsequently singulated, e.g., by performing a saw cut along saw lines 577 in FIG. 5, protective cap 530 is able to reduce or prevent damage to the dies as has been detailed elsewhere herein. After singulation, the package assembly process continues as discussed below.

A step 320 of method 300 is to attach the encapsulated die to a carrier. As an example, the carrier can be a copper foil or the like suitable for supporting a die. A possible process flow for step 320 may proceed as follows: (1) a cavity to hold the encapsulated die is etched in a starting copper foil; and (2) standard adhesive or film die attach processes are used to attach the die to the cavity in the copper foil. This process flow, as mentioned above, may result in a microelectronic package such as that shown in FIG. 2B. An alternative process flow, also mentioned above, would involve attaching the die to an un-etched copper foil and would, as an example, possibly result in a microelectronic package such as that shown in FIG. 2A.

A step 330 of method 300 is to form a plurality of build-up layers around the encapsulated die. For embodiments involving stacked packages, step 330 may be performed in such a way that the second surface of the encapsulated die is exposed at a surface of the package. (Doing so will help maintain the lowest possible package height (z-height), in that the die thickness would occupy part of the top package BGA interconnect space.) On the other hand, if package stacking is not a consideration, step 330 may be performed in such a way that the die is fully embedded, meaning that both sides of the die are covered with build-up layer material.

A possible process flow for step 330 may proceed as follows: (1) a dielectric film is laminated and vias are formed therein in the region outside of the die area; (2) vias are formed in the die area, exposing copper pads on the die; (3) the semi-additive process (SAP) is used to plate the vias and first metal layer of the substrate; (4) subsequent layers are formed using standard substrate SAP build-up procedures; (5) when the build-up is complete, the copper foil (introduced in step 320) is etched away. (It should be noted that SAP is only one of a number of possible plating processes; other processes like fully-additive, subtractive, or damascene-type processes could also be used, depending on the application.)

In one embodiment, method 300 further comprises roughening the surface of the protective cap. As mentioned above, this may be done in order to enhance the adhesion between the cap and the build-up layers. As an example, the roughening may be accomplished by plasma or chemical etching or the like, which may impart a roughness on the order of 0.2 - 1.0 µm.

Although the invention has been described with reference to specific embodiments, it will be understood by those skilled in the art that various changes may be made without departing from the spirit or scope of the invention. Accordingly, the disclosure of embodiments of the invention is intended to be illustrative of the scope of the invention and is not intended to be limiting. It is intended that the scope of the invention shall be limited only to the extent required by the appended claims. For example, to one of ordinary skill in the art, it will be readily apparent that the encapsulated die and the related structures and methods discussed herein may be implemented in a variety of embodiments, and that the foregoing discussion of certain of these embodiments does not necessarily represent a complete description of all possible embodiments.

Additionally, benefits, other advantages, and solutions to problems have been described with regard to specific embodiments. The benefits, advantages, solutions to problems, and any element or elements that may cause any benefit, advantage, or solution to occur or become more pronounced, however, are not to be construed as critical, required, or essential features or elements of any or all of the claims.

Moreover, embodiments and limitations disclosed herein are not dedicated to the public under the doctrine of dedication if the embodiments and/or limitations: (1) are not expressly claimed in the claims; and (2) are or are potentially equivalents of express elements and/or limitations in the claims under the doctrine of equivalents.

### Further Embodiments

In an embodiment there is provided an encapsulated die comprising: a substrate having a first surface, an opposing second surface, and intervening side surfaces; active devices located at the first surface of the substrate, the active devices adjacent to a plurality of electrically conductive layers that are separated from each other by a plurality of electrically insulating layers; and a protective cap over the first surface of the substrate, the protective cap containing an interconnect structure exposed at a surface thereof.

In an embodiment the protective cap extends over at least a portion of the intervening side surfaces.

In an embodiment the protective cap comprises a polymer mold compound.

In an embodiment the polymer mold compound contains filler particles comprising silica.

In an embodiment the polymer mold compound has a coefficient of thermal expansion between 5 and 12.

In an embodiment the polymer mold compound has a Young's modulus less than 10 GPa.

In an embodiment the interconnect structure is one of a plurality of interconnect structures exposed at the surface of the protective cap; and each one of the plurality of interconnect structures is substantially co-planar with each other one of the plurality of interconnect structures.

In an embodiment the surface of the protective cap has a roughness of between 0.1 and 1.0 micrometers.

In an embodiment there is provided a microelectronic package comprising: a package substrate; and an encapsulated die embedded within the package substrate, the encapsulated die comprising: a substrate having a first surface, an opposing second surface, and intervening side surfaces; active devices located at the first surface of the substrate, the active devices connected by a plurality of electrically conductive layers that are separated from each other by a plurality of electrically insulating layers; and a protective cap over the first surface of the substrate and over at least a portion of the intervening side surfaces, the protective cap containing an interconnect structure exposed at a surface thereof.

In an embodiment the protective cap extends over at least a portion of the intervening side surfaces.

In an embodiment the protective cap comprises a polymer mold compound.

In an embodiment the polymer mold compound contains filler particles comprising silica.

In an embodiment the polymer mold compound has a coefficient of thermal expansion between 5 and 12.

In an embodiment the polymer mold compound has a Young's modulus less than 10 GPa.

In an embodiment the interconnect structure is one of a plurality of interconnect structures exposed at the surface of the protective cap; and each one of the plurality of interconnect structures is substantially co-planar with each other one of the plurality of interconnect structures.

In an embodiment the surface of the protective cap the surface of the protective cap has a roughness of between 0.1 and 1.0 micrometers.

In an embodiment there is provided a method of manufacturing a microelectronic package, the method comprising: providing an encapsulated die comprising: a substrate having a first surface, an opposing second surface, and intervening side surfaces; active devices located at the first surface of the substrate, the active devices connected by a plurality of electrically conductive layers that are separated from each other by a plurality of electrically insulating layers; and a protective cap over the first surface of the substrate and over at least a portion of the intervening side surfaces, the protective cap containing an interconnect structure exposed at a surface thereof; attaching the encapsulated die to a carrier; and forming a plurality of build-up layers around the encapsulated die.

In an embodiment the method further comprises: leaving the second surface of the encapsulated die exposed.

In an embodiment the method further comprises roughening the surface of the protective cap.

In an embodiment the encapsulated die is formed on a wafer together with a plurality of other dies; the encapsulated die is separated from the other dies on the wafer in a singulation process prior to being attached to the carrier; and the protective cap is formed over the first surface of the substrate before the singulation process is performed.

## Claims

1. An encapsulated die comprising: a substrate having a first surface, an opposing second surface, and intervening side surfaces; and active devices located at the first surface of the substrate;
a protective cap over the first surface of the substrate and continuously extending in a single mold from the first surface, over at least a portion of the intervening side surfaces, the protective cap containing an interconnect structure exposed at a surface thereof; and
wherein the interconnect structure is coupled to one or more of the active devices.

2. The encapsulated die of claim 1, wherein the protective cap comprises a polymer mold compound.

3. The encapsulated die of claim 1, wherein the polymer mold compound contains filler particles comprising silica.

4. The encapsulated die of claim 1, wherein the interconnect structure is one of a plurality of interconnect structures that are substantially co-planar.

5. An encapsulated die comprising:
a substrate having a first surface, an opposing second surface, and intervening side surfaces; active devices located at the first surface of the substrate;
and a protective cap over the first surface of the substrate and continuously extending in a single mold from the first surface, over at least a portion of the intervening side surfaces, the protective cap containing an interconnect structure exposed at a surface thereof, wherein the interconnect structure is coupled to one or more of the active devices;
wherein the encapsulated die has been singulated through a portion of the protective cap adjacent to the intervening side surfaces, leaving at least a portion of the intervening side surfaces covered by a remaining portion of the protective cap.

6. The encapsulated die of claim 5, further including a package substrate coupled to the interconnect structure exposed through the protective cap.

7. The encapsulated die of claim 6, wherein the encapsulated die is partially embedded in the package substrate.

8. The encapsulated die of claim 6, wherein the encapsulated die is fully embedded in the package substrate.

9. A method of manufacturing an encapsulated die, the method comprising:
forming a number of active devices on a first surface of a number of dies on a wafer, the number of dies being separated from one another by partial side cut trenches;
forming a continuous protective cap over the first surface of the dies and within the partial side cut trenches;
forming an interconnect structure through the protective cap to connect with one or more active devices on the first surface; and
singulating the number of dies from the wafer by cutting through a portion of the protective cap within a middle of the partial side cut trenches and leaving a portion of the protective cap on remaining side surfaces of the partial side cut trenches.

10. The method of claim 9, further comprising: leaving a second surface opposite to the first surface of the encapsulated die exposed.

11. The method of claim 9, wherein singulating the number of dies includes saw cutting the number of dies.

12. The method of claim 9, further including laser scribing the partial side cut trenches.

13. The method of claim 9, further including attaching the encapsulated die to a substrate, wherein the interconnect structure is coupled to the substrate.
